# EUROPEAN PATENT SPECIFICATION

(11) **EP 2 603 066 B1**
(45) Date of publication and mention of the grant of the patent: **15.07.2015**
(21) Application number: 12405122.8
(22) Date of filing: 28.11.2012
(51) Int. Cl.: H05K 5/02, H01R 31/06

(54) **Multifunctional changing device**
Multifunktions-Austauschvorrichtung
Dispositif de changement multifonction

(30) Priority: 02.12.2011 EP 11405364
(43) Date of publication of application: 12.06.2013
(73) Proprietor: DET International Holding Limited, George Town, Grand Cayman (KY)
(72) Inventor: König, Magnus, 79369 Whyl (DE); Langenbacher, Patrick, 79602 Breisach (DE); Schlenker, Arnold, 79341 Kenzingen (DE); Walliser, Dietmar, 79312 Emmendingen (DE)
(74) Representative: Stäbler, Roman

(56) References cited:
- EP-A2- 1 571 511
- JP-A- 2005 318 770
- US-A1- 2008 020 633

## Description

### Technical Field

The invention relates to a changing device for a power electronics gear, in particular an inverter, according to the preamble of claim 1 as well as to a power electronics gear according to claim 17.

### Background Art

Electrical devices and in particular inverters typically comprise certain components which need to be replaced from time to time. Such components can for example be batteries (such as batteries for real-time clocks for example) or wear parts (such as connections for example). The inverters that are known up to now have the disadvantage that they have to be opened up for replacing such components like batteries or wear parts. In particular, screws typically have to be removed for opening the inverters. This can be a severe disadvantage, in particular in humid, dusky or other extreme environments. Another disadvantage of the fact that inverters have to be opened up and closed by removing/replacing screws in order to replace certain components is that this procedure can be considerably time-consuming. However, outage time due to maintenance must be minimized In many power electronic applications.

EP 1 571 51 (ABB OY) discloses a configuration tool which is capable of electrifying at least a memory of a frequency converter. Hence, the frequency converter does not need to be connected to an electric network in order to feed configuration data into its memory, but it suffices to connect the configuration tool with the frequency converter. The configuration tool may be portable and include a battery for electrifying the memory of the frequency converter. Further, the configuration tool comprises a wired interface via which it may be connected to the frequency converter for the duration of the configuration, during which connector poles of the wired interface are brought into contact with an interface, such as connector poles of the frequency converter.

US 2008/020633 (Montgomery James et al.) discloses a USB port connector for motor vehicles. The USB port may be located in the lighter connection of a vehicle and comprises a barrel portion with a nut portion which may be threadably connected with the barrel portion. The barrel portion may be inserted through an opening of a cigarette lighter in a vehicle. An electrical connection is provided on one end of the barrel portion for connecting the USB port to computer hardware on the vehicle. The electrical connection may have connection pins for connection to a female USB connector, which is further covered by a retainer clip with a biased catch. For repair of the USB connector, the combined female USB connector and retainer clip may be removed from the barrel portion by biasing the catch to permit withdrawal of the combined USB connector and retainer clip.

### Summary of the invention

it is the object of the invention to create a changing device pertaining to the technical field initially mentioned, that resolves or at least reduces the above-mentioned disadvantages. In particular, it is the object of the invention to create a changing device that allows easy and quick removal and/or replacement of components such as batteries or wear parts in power electronic gear such as, for example, inverters.

The solution of the invention is specified by the features of claim 1. According to the invention, a changing device for insertion and removal of a component, in particular an electrical component, into a power electronics gear, in particular an inverter, wherein a wall of a housing of the power electronics gear comprises an opening fitted to receive the changing device, comprises a removable plug-in board. For example, such a plug-in board can be an electronic circuit board, typically fitted to carry technical, preferably electronic equipment.

The invention has the advantage that it makes an easy and quick removal and/or replacement of components such as batteries or wear parts in power electronic gear such as inverters possible.

In a preferred embodiment, the plug-in board comprises a battery fitting and/or a battery box or battery case or battery compartment and/or a battery and/or another changing component. The battery fitting is typically configured to receive a real-time battery, preferably a coin cell battery or a button cell battery. A battery fitting and/or a battery on the plug-in board has the advantage that the battery can be easily replaced by removing the plug-in board from the changing device and thus from the power electronic gear, replacing the battery on the plug-in board and then replacing the plug-in board in the changing device.

In a preferred embodiment, the plug-in board and/or the changing device comprise(s) a USB connection and/or an RJ45 connection and/or an I/O connection and/or another - preferably electric or electronic - connection.

The changing device comprises a fixture configured to receive the plug-in board. Such a fixture of the changing device is typically securely fastened to the power electronics gear, in particular to its housing. The plug-in board can typically be inserted in the fixture and/or be removed from the fixture. The use of such a fixture has the advantage that a changing process can be simplified through minimization of components that need to be removed during this process.

The fixture preferably comprises an insertion guidance for receiving the plug-in board. The insertion guidance is typically formed by two rail elements on opposite sides of the fixture. Such an insertion guidance has the advantage to allow a quick, easy and controlled movement of the plug-in board in the fixture.

In typical embodiments, the fixture comprises a connector fitting for receiving an electric connector. This connector typically comprises connection holes on a front side and a back side, wherein the connection holes of the back side are connected to cables that connect the connector to an internal circuit of the power electronics gear and wherein the connection holes of the front side are configured to receive connecting pins of the plug-in board. The connector is thus configured to establish a connection between the plug-in board and the circuit of the inverter. The connector fitting typically comprises at least one clip for fastening the connector in the connector fitting.

The fixture typically comprises a first thread for fixing and/or securing the fixture in the opening of the wall of the housing of the power electronics gear. Preferably, the first thread is configured in such a way that it can be inserted into the opening, preferably without touching the wall of the housing, and that it can at least partially be plunged through the opening such that at least a part of the first thread extends into an interior of the power electronics gear. The first thread is preferably designed such that a nut, preferably a ring nut, can be screwed onto the first thread from the interior of the power electronics gear in order to fix and/or secure and/or fasten the fixture in/to the wall of the housing and/or the opening.

The fixture typically comprises a cover ring for covering a remaining gap between the first thread and the opening when the changing device is secured in the opening. This cover ring is typically also configured to act as a blocking arrestor for blocking the insertion of the fitting and/or the first thread into the opening at a certain position. The cover ring is preferably configured to assure a proper fixing of the fixture in the wall in combination with the nut.

The changing device preferably comprises a cap for protecting the changing device for example against humidity or dusk. The cap typically comprises two parts, wherein at least one part comprises a cap thread, preferably an internal cap thread.

In preferred embodiments, the fixture comprises a second thread for screwing the cap onto the fixture. Alternatively, it is also possible that the fixture is configured in such a way that the cap can be hoisted onto the fixture. The cap is preferably large enough to offer sufficient space for a USB-stick, preferably mini USB-stick with length of less than 20 mm, preferably less than 15 mm, when the cap is securely fastened to the fixture. This has the advantage that a USB-stick can be connected to the USB connector of the plug-in board in order to log data of the inverter while being covered and protected by the cap.

In a preferred embodiment, the changing device comprises a connecting means, in particular a connecting strip, for connecting the cap to the fixture and/or the housing. Like this, the cap cannot be lost when removed from and/or screwed off the fixture.

The connecting means typically comprises a first substantially round opening for receiving and/or enlacing the cap at least partially and/or a second substantially round opening for receiving and/or enlacing the fixture at least partially, preferably between the cover ring and the first thread. The second opening is typically configured to be clamped between the cover ring and the wall of the housing. This ensures a safe connection between the cap and the fixture and/or power electronic gear.

The changing device preferably comprises a cover plate for covering an opening between the fixture and the fixture-mounted plug-in board, preferably an opening between the fixture and the fixture-mounted plug-in board and/or the USB connection and/or the RJ45 connection and/or the I/O connection and/or another technical component mounted on the plug-in board. The cover plate typically has an outer outline that fits into an inner outline of the fixture and/or an inner outline of the second thread. The cover plate typically comprises a clipping fin configured to allow an easy mounting of the cover plate in the fixture.

In a preferred embodiment, the changing device comprises a seal for sealing a contact region between the fixture and the cap when the cap is mounted on the fixture and/or between the fixture and another component that is mounted on the fixture.

In preferred embodiments, the changing device comprises a cable link for linking the power electronics gear to an external device such as a data logger, wherein the cable link comprises a cable cap and/or a cable seal and/or a cable gland. The cable cap is typically an IP 65 cap and/or compliant with IP 65. The cable link does not have to be an integral part of the changing device; it can also be a replacement part, for example for replacing the cap when needed.

Another aspect of the present invention relates to a protective earth connector which enables an electrical connection between a plug-in board or any other electrical plug-in component and the wall of a power electronics gear. Preferably, the protective earth connector is used in connection with a fixture and plug-in board arrangement according to the present invention. However, the protective earth connector may also be used in connection with various other types of electrical plug-in elements, such as e.g. sensor modules, memory cards and the like. The protective earth connector preferably comprises means to contact the wall of the housing of the power electronics gear as well as means to contact said plug-in board or electrical plug-in component in order to establish an electrical connection between the plug-in board or electrical plug-in component and the wall of the housing. Usually, the housing of a power electronics gear must comprise an adequate earthing system such as to meet various safety regulations. Hence, a protective earth connector according to the present invention provides a simple means to connect an electrical plug-in component or plug-in board with an earthing system to prevent damage of the plug-in component or plug-in board.

The protective earth connector is preferably configured to be removably arranged on the fixture such that it contacts the wall of the housing of the power electronics gear and the plug-in board.

Preferably, the protective earth connector comprises at least one arm configured to be biased towards the plug-in board such as to bear upon said plug-in board. The biasing of the arm allows for a reliable contact between the protective earth element and the plug-in board irrespective of the type of plug-in board inserted into the fixture. Further, by providing a biased arm, an electrical connection between the plug-in board and the wall of the power electronics gear will be established automatically when inserting a plug-in board into the fixture, since the arm will glide onto the plug-in board upon its insertion. The arm will then be firmly pressed against the surface of the plug-in board by the biasing force. Analogously, the electrical connection is easily interrupted once a plug-in board is removed from the fixture. Thus, a biased arm allows a quick exchange of a plug-in board without the need to remove or disconnect any additional part.

Further preferably, the protective earth connector comprises two biased arms arranged such as to contact the plug-in board on both its lateral edges. Such a configuration offers an additional security in the case that one arm does not properly contact the plug-in board.

The protective earth connector preferably further comprises a flange adapted to be slid onto the fixture. The flange comprises at least one surface configured to contact the surface of the wall of the power electronics gear. The at least one surface is preferably substantially flat. Alternatively, the surface may be of another shape which is complementary to the shape of the wall of the power electronics gear. This provides for a reliable contact between the protective earth connector and the wall of the power electronics gear. Additionally, this contact is established over a relatively large surface area, which further increases the reliability of the electrical connection.

A "flange" according to the present invention is understood as being a surface body comprising an opening. The flange is most preferably in the form of a flat ring having a central opening with a diameter enabling the insertion of the fixture there through. Alternatively, the flange may also be on a different shape, e.g. rectangular or of an arbitrary polygonal shape. The opening is adapted to have a shape and dimension which is substantially equal to the form and dimension of the fixture, such that the protective earth connector may be slid onto the fixture.

Preferably, the protective earth connector comprises guidance means configured to be arranged onto the insertion guidance of the fixture, e.g. the guidance means are provided as sleeves which may be slid onto the guidance means. This allows to position the protective earth connector in a defined orientation on the fixture thus enhancing the contact between the at least one biased arm and a plug-in board.

A power electronics gear, in particular an inverter, according to the invention typically comprises a changing device according to the invention.

Other advantageous embodiments and combinations of features come out from the detailed description below and the totality of the claims.

### Brief description of the drawings

The drawings used to explain the embodiments show:
- Fig. 1:: a 3D-view of a changing device according to the invention comprising a USB connection;
- Fig. 2:: a 3D-view of a changing device according to the invention comprising an I/O connection;
- Fig. 3:: a 3D-view of a changing device according to the invention comprising an RJ45 connection;
- Fig. 4:: a 3D-view of a changing device according to the invention comprising an I/O connection and a cable link;
- Fig. 5:: a perspective view of a protective earth connector according to the present invention; and
- Fig. 6:: a 3D-view of the protective earth connector of Fig. 5 in use.

In the figures, the same components are given the same reference symbols.

### Preferred embodiments

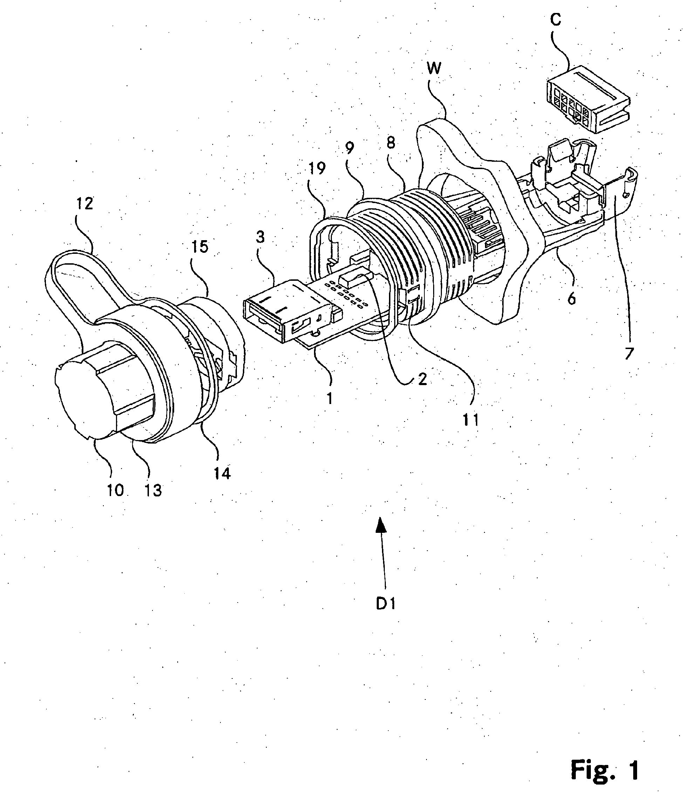

Figure 1 shows a 3D-view of a first embodiment of a changing device D1 according to the invention.

The changing device D1 comprises a plug-in board 1 that can be inserted in and removed from a fixture 6 of the changing device D 1. A changing component 2 and a USB connection 3 are mounted on the plug-in board 1. Instead of or in addition to the changing component 2, a battery fitting containing a button cell battery (both not shown) could be mounted on the plug-in board 1.

The fixture 6 can be mounted into an opening in a wall W of an inverter housing. The fixture 6 comprises a connector fitting 7 which is configured to receive and hold an electric connector C. This electric connector C is configured to establish an electric connection between the plug-in board 1 and an inverter circuit (not shown). The fixture 6 further comprises a first external thread 8 for securing the fixture 6 in the opening of the wall W by means of a ring nut (not shown) which is screwed onto the first external thread 8 from an interior of the inverter. The fixture 6 also comprises a cover ring 9. The cover ring 9 separates the first thread 8 from a second external thread 11 of the fixture 6. A cap 10 can be screwed onto this second thread 11 in order to close the entire changing device D1 when mounted in the wall W of the inverter housing. The cap 10 has two parts, namely a small front part and a large back part. Between the large back part and small front part of the cap 10, a connecting means 12 is fixed to the cap 10 by means of a first opening 13. In addition to the first opening 13, the connecting means 12 comprises second opening 14 by which the connecting means 12 and therefore the cap 10 can be fixed to the inverter. This fixing takes place by clamping the second opening 14 between the cover ring 9 and the wall W when securing the fixture 6 in the opening of the wall W.

Figure 1 also shows a cover plate 15 that is configured to close a remaining gap present between the USB connection 3 and the fixture 6 when the plug-in board 1 is completely inserted into the fixture 6. An outer outline of the cover plate 15 is formed as a complement to an inner outline of the second thread 11 such that the cover plate 15 fits tightly into the second thread 11 and/or the fixture 6. When the cover plate 15 is mounted into the fixture 6, only the USB connection 3 protrudes partially through the cover plate 15. The changing device D1 shown in Figure 1 also shows a seal 19 fixed to an outer rim of the fixture 6. This seal 19 seals a contact region between the cap 10 and the fixture 6 when the cap 10 is screwed onto the second thread 11.

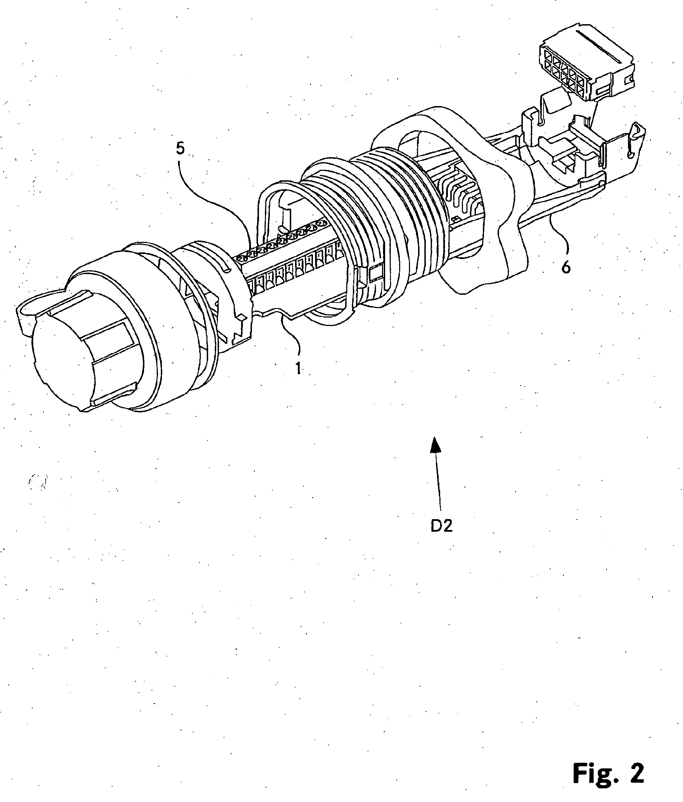

Figure 2 shows a 3D-view of a second embodiment of a changing device D2 according to the invention. The changing device D2 differs from the changing device D1 shown in Figure 1 in that the plug-in board 1 that can be inserted into the fixture 6 comprises an I/O connection 5 instead of a USB connection 3.

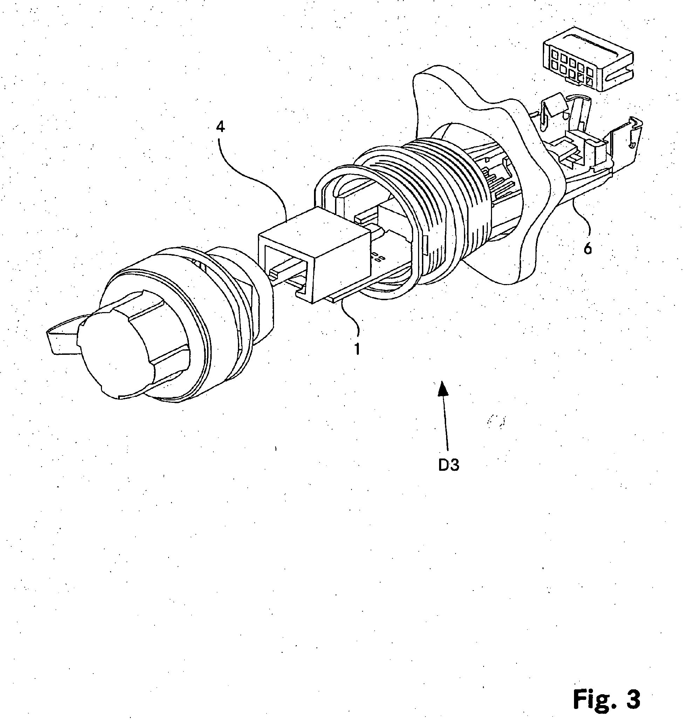

Figure 3 shows a 3D-view of a third embodiment of a changing device D3 according to the invention. The changing device D3 differs from the changing devices D1 and D2 shown in Figure 1 and Figure 2, respectively, in that the plug-in board 1 that can be inserted into the fixture 6 comprises an RJ45 connection 4 instead of a USB connection 3 or an I/O connection 5, respectively.

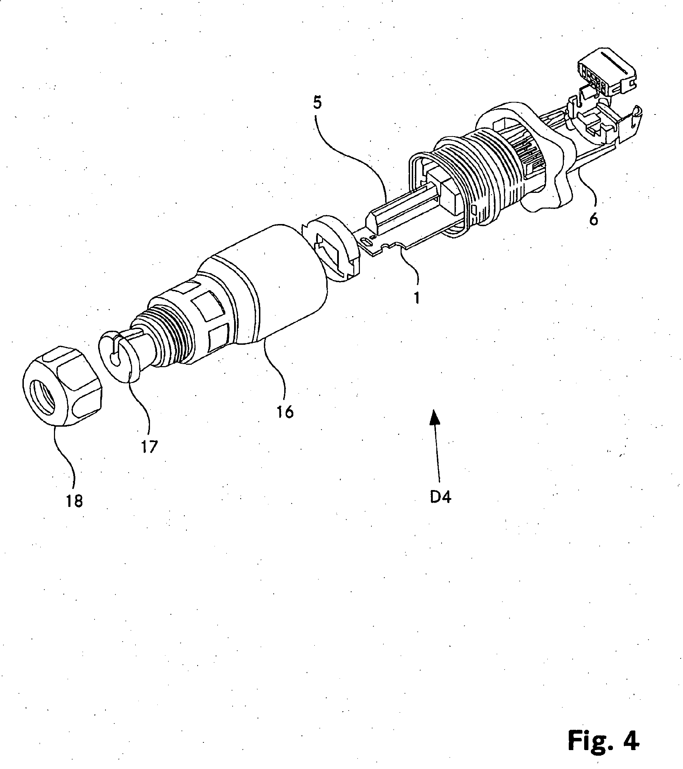

Figure 4 shows a 3D-view of a fourth embodiment of a changing device D4 according to the invention. The changing device D4 differs from the previously described changing devices D1, D2 and D3 in that the changing device D4 comprises a cable link composed of a cable cap 16, a cable seal 17 and a cable gland 18 instead of a cap 10 and a connecting means 12. The fact that the latter are not shown in Figure 4 does, however, not mean that an embodiment of the invention cannot comprise cap 10, connecting means 12 and cable link at the same time: this is rather of course also possible. The cable link shown in Figure 4 can be used to safely connect and seal a cable (not shown) to the changing device D4. Such a cable could, for example, connect the inverter to an external data logger via the I/O connection 5.

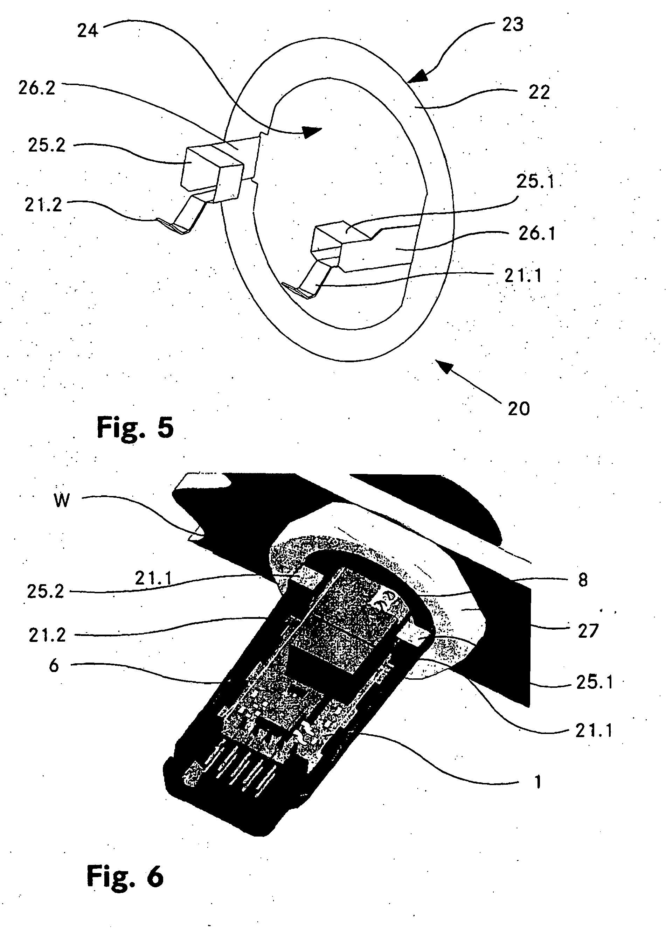

Figure 5 shows a perspective view of a protective earth connector 20 according to the invention. The protective earth connector 20 comprises a flange 22 having a substantially flat surface 23 (facing away of the viewer) and a central opening 24. In use, the protective earth connector 20 may be slid onto a fixture 6 by means of the opening 24. The surface 23 will contact the wall W of a power electronics gear. Further, on the side opposite the surface 23 the protective earth connector 20 further comprises two brackets 26.1, 26.2 which extend substantially perpendicularly away of the flange. The brackets 26.1, 26.2 are each connected to an arm 21.1, 21.2 which are configured to be biased against a surface of a plug-in board 1 inserted into the fixture 6 when the protective earth connector 20 is in use. In the embodiment shown, the arms 21.1, 21.2 are provided as leaf springs. To facilitate the sliding of the protective earth connector 20 on the fixture 6, guidance means 25.1, 25.2 are provided on the brackets 26.1, 26.2. These guidance means 25.1, 25.2 are configured such that they may be slid onto appropriate guides or rails provided on the fixture 6. In the embodiment shown, the guidance means 25.1, 25.2 are configured as square brackets. The protective earth connector 20 is preferably made of a single piece of metal, e.g. a metal sheet which is subjected to die cutting and bending.

Figure 6 depicts a protective earth connector 20 in use in a 3D-view. A plug-in board 1 is inserted into the fixture 6. The fixture 6 itself is inserted within a power electronics gear and therefore extends through the wall W of said gear. The figure hence shows the arrangement of the fixture 6 in the interior of the power electronics gear. The protective earth connector 20 is slid onto the fixture 6 and onto the first thread 8. A nut 27 is screwed on the first thread 8 to attach the fixture 6 to the wall W, thereby clamping the flange 21 of the protective earth connector 20 between the nut 27 and the wall W of the power electronics gear. As can be seen on this figure, the guidance means 25.1, 25.2 are slid onto corresponding rails provided on the fixture 6 such as to enable the proper orientation of the protective earth connector 20. The brackets 26.1, 26.2 are dimensioned in such a way that the arms 21.1, 21.2 and the guidance means 25.1, 25.2 are spaced apart from the flange 21 in a sufficient manner not to interfere with the first thread 8. The two arms 21.1, 21.2 are biased towards a surface of the plug-in board 1 and are hence snugly pressed onto said surface. Hence, by means of the protective earth connector 20, an electrical connection is established between the plug-in board 1, through the arms 21.1, 21.2, the brackets 26.1, 26.2 to the flange 21 which is in electrical contact with the wall W of the power electronics gear. Hence, any electrical charge accumulated on the plug-in board 1, e.g. by a malfunction, is discharged to the wall W of the power electronics gear which thus acts as protective earth for the plug-in board 1.

The invention is by no means limited to the embodiments described here. The scope of protection is rather defined by the patent claims.

## Claims

1. Changing device (D1, D2, D3, D4) for insertion and removal of a component (2), such as battery or a wear part, into and out of a power electronics gear, in particular an inverter, comprising:
a) a fixture (6) inserted into an opening of a wall (W) of a housing of the power electronics gear and secured to said wall (W), said fixture (6) comprising a connector fitting (7) for receiving and holding an electric connector (C); and
b) a plug-in board (1) which can be inserted in the fixture (6) and/or removed from the fixture (6) and comprising the component (2) and connecting pins receivable in said electric connector (C).

2. Changing device (D1, D2, D3, D4) according to claim 1, **characterized in that** the component (2) is a battery fitting and/or a battery and/or another changing component (2).

3. Changing device (D1, D2, D3, D4) according to any of the previous claims, **characterized in that** the plug-in board (1) comprises a USB connection (3) and/or an RJ45 connection (4) and/or an I/O connection (5) and/or another connection.

4. Changing device (D1, D2, D3, D4) according to any of claims 1 to 3, **characterized in that** the fixture (6) comprises an insertion guidance for receiving the plug-in board (1).

5. Changing device (D 1, D2, D3, D4) according to any of the claims 1 to 4, **characterized in that** the fixture (6) comprises a first thread (8) which is designed such that a nut (27), preferably a ring nut, can be screwed onto said first thread (8) for securing the fixture (6) in said opening of the wall (W).

6. Changing device (D1, D2, D3, D4) according to any of the claims 1 to 5, **characterized in that** the fixture (6) comprises a cover ring (9) for covering a remaining gap between the first thread (8) and the opening when the changing device (D1, D2, D3, D4) is secured in the opening of the wall (W).

7. Changing device (D1, D2, D3, D4) according to any of the previous claims, **characterized in that** the changing device (D1, D2, D3, D4) comprises a cap (10) for protecting the changing device (D1, D2, D3, D4).

8. Changing device (D1, D2, D3, D4) according to any of the claims 1 to 7, **characterized in that** the fixture (6) comprises a second threat (11) for screwing the cap (10) onto the fixture (6).

9. Changing device (D1, D2, D3, D4) according to any of the claims 7 or 8, **characterized in that** the changing device (D1, D2, D3, D4) comprises a connecting means (12) for connecting the cap (10) to the fixture (6) and/or the housing.

10. Changing device (D1, D2, D3, D4) according to claim 9, **characterized in that** the connecting means (12) comprises a first substantially round opening (13) for receiving and/or enlacing the cap (10) at least partially and/or a second substantially round opening (14) for receiving and/or enlacing the fixture (6) at least partially, preferably between the cover ring (9) and the first thread (8).

11. Changing device (D1, D2, D3, D4) according to any of the claims 1 to 10, **characterized in that** the changing device (D1, D2, D3, D4) comprises a cover plate (15) for covering an opening between the fixture (6) and the fixture-mounted plug-in board (1).

12. Changing device (D1, D2, D3, D4) according to any of the claims 7 to 11, **characterized in that** the changing device (D1, D2, D3, D4) comprises a seal (19) for sealing a contact region between the fixture (6) and the cap (10) when the cap (10) is mounted on the fixture (6) and/or for sealing a contact region between the fixture (6) and another component that is mounted on the fixture (6).

13. Changing device (D1, D2, D3, D4) according to any of the previous claims, **characterized in that** the changing device (D1, D2, D3, D4) comprises a cable link for linking the power electronics gear with an external device such as a data logger, wherein the cable link comprises a cable cap (16) and/or a cable seal (17) and/or a cable gland (18).

14. Changing device (D1, D2, D3, D4) according to any of claims 1 to 13, **characterized In that** a protective earth connector (20) is removably arranged on the fixture (6) such that it contacts the wall (W) of the housing of the power electronics gear and the plug-in board (1) to establish an electrical connection between said wall (W) and said plug-in board (1).

15. Changing device (D1, D2, D3, D4) according to claim 14, **characterized in that** said protective earth connector (20) comprises at least one arm (21.1, 21.2) which is configured to be biased towards the plug-in board (1) such as to bear upon said plug-in board (1).

16. Changing device (D1, D2, D3, D4) according to claim 14 or 15, **characterized in that** said protective earth connector (20) further comprises a flange (22) adapted to be slid onto the fixture (6) and having a least one surface (23) configured to contact the surface of the wall (W) of the power electronics gear, said at least one surface (23) preferably being substantially flat.

17. Power electronics gear, in particular inverter, **characterized in that** the power electronics gear comprises a changing device (D 1, D2, D3, D4) according to any of the claims 1 to 16.

## Patentansprüche

1. Austauschvorrichtung (D1, D2, D3, D4) zum Einsetzen und Entfernen einer Komponente (2) wie etwa einer Batterie oder eines Verschleißteils in ein Leistungselektronikgerät hinein und aus diesem heraus, insbesondere einen Inverter, umfassend:
a) eine Halterung (6), die in einer Öffnung einer Wand (W) eines Gehäuses des Leistungselektronikgeräts eingesetzt und an der Wand (W) gesichert ist, wobei die Halterung (6) ein Verbinderanschlusselement (7) zum Aufnehmen und Halten eines elektrischen Verbinders (C) umfasst; und
b) eine Einsteckplatine (1), die in die Halterung (6) eingesetzt und/oder aus der Halterung (6) entfernt werden kann und die Komponente (2) und verbindende Stifte umfasst, die in dem elektrischen Verbinder (C) aufgenommen werden können.

2. Austauschvorrichtung (D1, D2, D3, D4) nach Anspruch 1, dadurch gekennzeichet, dass die Komponente (2) ein Batterieanschlusselement und/oder eine Batterie und/oder eine andere Austauschkomponente (2) ist.

3. Austauschvorrichtung (D1, D2, D3, D4) nach einem der vorhergehenden Ansprüche, **dadurch gekennzeichnet, dass** die Einsteckplatine (1) einen
USB-Anschluss (3) und/oder einen RJ45-Anschluss (4) und/oder einen E/A-Anschluss (5) und/oder einen anderen Anschluss umfasst.

4. Austauschvorrichtung (D1, D2, D3, D4) nach einem der Ansprüche 1 bis 3, **dadurch gekennzeichnet, dass** die Halterung (6) eine Einsetzführung zum Aufnehmen der Einsteckplatine (1) umfasst.

5. Austauschvorrichtung (D1, D2, D3, D4) nach einem der Ansprüche 1 bis 4, **dadurch gekennzeichnet, dass** die Halterung (6) ein erstes Gewinde (8) umfasst, das derart ausgelegt ist, dass eine Mutter (27), bevorzugt eine Ringmutter, auf das erste Gewinde (8) geschraubt werden kann, um die Halterung (6) in der Öffnung der Wand (W) zu sichern.

6. Austauschvorrichtung (D1, D2, D3, D4) nach einem der Ansprüche 1 bis 5, **dadurch gekennzeichnet, dass** die Halterung (6) einen Abdeckring (9) zum Abdecken eines verbleibenden Spalts zwischen dem ersten Gewinde (8) und der Öffnung umfasst, wenn die Austauschvorrichtung (D1, D2, D3, D4) in der Öffnung der Wand (W) gesichert ist.

7. Austauschvorrichtung (D1, D2, D3, D4) nach einem der vorhergehenden Ansprüche, **dadurch gekennzeichnet, dass** die Austauschvorrichtung (D1, D2, D3, D4) eine Kappe (10) zum Schützen der Austauschvorrichtung (D1, D2, D3, D4) umfasst.

8. Austauschvorrichtung (D1, D2, D3, D4) nach einem der Ansprüche 1 bis 7, **dadurch gekennzeichnet, dass** die Halterung (6) ein zweitens Gewinde (11) zum Schrauben der Kappe (10) auf die Halterung (6) umfasst.

9. Austauschvorrichtung (D1, D2, D3, D4) nach einem der Ansprüche 7 oder 8, **dadurch gekennzeichnet, dass** die Austauschvorrichtung (D1, D2, D3, D4) ein Verbindungsmittel (12) zum Verbinden der Kappe (10) mit der Halterung (6) und/oder dem Gehäuses umfasst.

10. Austauschvorrichtung (D1, D2, D3, D4) nach Anspruch 9, **dadurch gekennzeichnet, dass** das Verbindungsmittel (12) eine erste, im Wesentlichen runde Öffnung (13) zum Aufnehmen und/oder Umschlingen der Kappe (10) mindestens teilweise und/oder eine zweite, im Wesentlichen runde Öffnung (14) zum Aufnehmen und/oder Umschlingen der Halterung (6) mindestens teilweise, bevorzugt zwischen dem Abdeckring (9) und dem ersten Gewinde (8), umfasst.

11. Austauschvorrichtung (D1, D2, D3, D4) nach einem der Ansprüche 1 bis 10, **dadurch gekennzeichnet, dass** die Austauschvorrichtung (D1, D2, D3, D4) eine Abdeckplatte (15) zum Bedecken einer Öffnung zwischen der Halterung (6) und der halterungsmontierten Einsteckplatine (1) umfasst.

12. Austauschvorrichtung (D1, D2, D3, D4) nach einem der Ansprüche 7 bis 11, **dadurch gekennzeichnet, dass** die Austauschvorrichtung (D1, D2, D3, D4) eine Dichtung (19) zum Abdichten eines Kontaktgebiets zwischen der Halterung (6) und der Kappe (10) umfasst, wenn die Kappe (10) an der Halterung (6) montiert ist, und/oder zum Abdichten eines Kontaktgebiets zwischen der Halterung (6) und einer weiteren Komponente, die an der Halterung (6) montiert ist,

13. Austauschvorrichtung (D1, D2, D3, D4) nach einem der vorhergehenden Ansprüche, **dadurch gekennzeichnet, dass** die Austauschvorrichtung (D1, D2, D3, D4) eine Kabelverbindung zum Verbinden des Leistungselektronikgeräts mit einer externen Vorrichtung wie etwa einem Datenlogger umfasst, wobei die Kabelverbindung eine Kabelkappe (16) und/oder eine Kabeldichtung (17) und/oder eine Kabelstopfbuchse (18) umfasst.

14. Austauschvorrichtung (D1, D2, D3, D4) nach einem der Ansprüche 1 bis 13, **dadurch gekennzeichnet, dass** ein Schutzerdverbinder (20) entfernbar derart an der Halterung (6) angeordnet ist, dass er die Wand (W) des Gehäuses des Leistungselektronikgeräts und die Einsteckplatine (1) kontaktiert, um zwischen der Wand (W) und der Einsteckplatine (1) eine elektrische Verbindung herzustellen.

15. Austauschvorrichtung (D1, D2, D3, D4) nach Anspruch 14, **dadurch gekennzeichnet, dass** der Schutzerdverbinder (20) mindestens einen Arm (21.1, 21.2) umfasst, der konfiguriert ist, zu der Einsteckplatine (1) vorgespannt zu sein, so dass er an der Einsteckplatine (1) anliegt.

16. Austauschvorrichtung (D1, D2, D3, D4) nach Anspruch 14 oder 15, **dadurch gekennzeichnet, dass** der Schutzerdverbinder (20) weiterhin einen Flansch (22) umfasst, der ausgelegt ist, auf die Halterung (6) geschoben zu werden, und mindestens eine Oberflache (23) aufweist, die konfiguriert ist zum Kontaktierten der Oberfläche der Wand (W) des Leistungselektronikgeräts, wobei die mindestens eine Oberfläche (23) bevorzugt im Wesentlichen flach ist.

17. Leistungselektronikgerät, insbesondere Inverser, **dadurch gekennzeichnet, dass** das Leistungselektronikgerät eine Austauschvorrichtung (D1, D2, D3, D4) nach einem der Ansprüche 1 bis 16 umfasst.

## Revendications

1. Dispositif de changement (D1, D2, D3, D4) pour insérer et retirer un composant (2), comme une batterie ou une pièce d'usure, dans et hors d'un équipement à électronique de puissance, notamment un onduleur, comprenant :
a) un appareil (6) inséré dans une ouverture d'une paroi (W) d'un boîtier de l'équipement à électronique de puissance et fixé à ladite paroi (W), lequel appareil (6) comprend un raccord de connecteur (7) pour recevoir et maintenir un connecteur électrique (C) ; et
b) une carte enfichable (1) pouvant être insérée dans l'appareil (6) et/ou être retirée de l'appareil (6) et comprenant le composant (2) et des broches de connexion venant se loger dans le connecteur électrique (C).

2. Dispositif de changement (D1, D2, D3, D4) selon la revendication 1, **caractérisé en ce que** le composant (2) est un appareil de type batterie et/ou une batterie et/ou un autre composant de changement (2).

3. Dispositif de changement (D1, D2, D3, D4) selon l'une quelconque des revendications précédentes, **caractérisé en ce que** la carte enfichable (1) comprend une connexion USB (3) et/ou une connexion RJ45 (4) et/ou une connexion I/O (5) et/ou une autre connexion.

4. Dispositif de changement (D1, D2, D3, D4) selon l'une quelconque des revendications 1 à 3, **caractérisé en ce que** l'appareil (6) comprend un guide d'insertion pour recevoir la carte enfichable (1).

5. Dispositif de changement (D1, D2, D3, D4) selon l'une quelconque des revendications 1 à 4, **caractérisé en ce que** l'appareil (6) comprend un premier filetage (8) qui est conçu de sorte qu'un écrou (27), de préférence un écrou annulaire, puisse être vissé sur le premier filetage (8) afin de fixer l'appareil (6) dans l'ouverture de la paroi (W).

6. Dispositif de changement (D1, D2, D3, D4) selon l'une quelconque des revendications 1 à 5, **caractérisé en ce que** l'appareil (6) comprend un anneau de couverture (9) afin de couvrir un jour restant entre le premier filetage (8) et l'ouverture lorsque le dispositif de changement (D1, D2, D3, D4) est fixé dans l'ouverture de la paroi (W).

7. Dispositif de changement (D1, D2, D3, D4) selon l'une quelconque des revendications précédentes, **caractérisé en ce que** le dispositif de changement (D1, D2, D3, D4) comprend un capuchon (10) afin de protéger le dispositif de changement (D1, D2, D3, D4).

8. Dispositif de changement (D1, D2, D3, D4) selon l'une quelconque des revendications 1 à 7, **caractérisé en ce que** l'appareil (6) comprend un second filetage (11) afin de visser le capuchon (10) sur l'appareil (6).

9. Dispositif de changement (D1, D2, D3, D4) selon l'une quelconque des revendications 7 ou 8, **caractérisé en ce que** le dispositif de changement (D1, D2, D3, D4) comprend un moyen de connexion (12) permettant de connecter le capuchon (10) à l'appareil (6) et/ou au boîtier.

10. Dispositif de changement (D1, D2, D3, D4) selon la revendication 9, **caractérisé en ce que** le moyen de connexion (12) comprend une première ouverture essentiellement ronde (13) pour recevoir ou enlacer le capuchon (10) au moins partiellement et/ou une seconde ouverture essentiellement ronde (14) pour recevoir et/ou enlacer l'appareil (6) au moins partiellement, de préférence entre l'anneau de couverture (9) et le premier filetage (8).

11. Dispositif de changement (D1, D2, D3, D4) selon l'une quelconque des revendications 1 à 10, **caractérisé en ce que** le dispositif de changement (D1, D2, D3, D4) comprend une plaque de couverture (15) pour couvrir une ouverture entre l'appareil (6) et la carte enfichable (1) montée sur l'appareil.

12. Dispositif de changement (D1, D2, D3, D4) selon l'une quelconque des revendications 7 à 11, **caractérisé en ce que** le dispositif de changement (D1, D2, D3, D4) comprend un joint (19) pour sceller une région de contact entre l'appareil (6) et le capuchon (10) lorsque le capuchon (10) est monté sur l'appareil (6) et/ou pour sceller une région de contact entre l'appareil (6) et un autre composant monté sur l'appareil (6).

13. Dispositif de changement (D1, D2, D3, D4) selon l'une quelconque des revendications précédentes, **caractérisé en ce que** le dispositif de changement (D1, D2, D3, D4) comprend une liaison par câble pour relier l'équipement à électronique de puissance à un dispositif externe, comme un enregistreur de données, laquelle liaison par câble comprend un capuchon de câble (16) et/ou un joint de câble (17) et/ou un presse-étoupe (18).

14. Dispositif de changement (D1, D2, D3, D4) selon l'une quelconque des revendications 1 à 13, **caractérisé en ce qu'**un connecteur de terre de protection (20) est disposé de manière amovible sur l'appareil (6) de sorte qu'il entre en contact avec la paroi (W) du boîtier de l'équipement à électronique de puissance entre la paroi (W) et la carte enfichable (1).

15. Dispositif de changement (D1, D2, D3, D4) selon la revendication 14, **caractérisé en ce que** le connecteur de terre de protection (20) comprend au moins un bras (21.1, 21.2) qui est conçu pour être poussé vers la carte enfichable (1) de manière à reposer sur la carte enfichable (1).

16. Dispositif de changeant (D1, D2, D3, D4) selon les revendications 14 ou 15, **caractérisé en ce que** le connecteur de terre de protection (20) comprend en outre au moins un flanc (22) conçu pour être coulissé sur l'appareil (6) et comprenant au moins une surface (23) conçue pour entrer en contact avec la surface de la paroi (W) de l'équipement à électronique de puissance, ladite au moins une surface (23) étant de préférence essentiellement plane.

17. Equipement à électronique de puissance, notamment un onduleur, **caractérisé en ce que** l'équipement à électronique de puissance comprend le dispositif de changement (D1, D2, D3, D4) selon l'une quelconque des revendications 1 à 16.
